# EUROPEAN PATENT APPLICATION

(11) **EP 3 913 470 A1**
(43) Date of publication of application: **24.11.2021**
(21) Application number: 20742067.0
(22) Date of filing: 09.01.2020
(51) Int. Cl.: G06F 3/0354

(54) **POSITION DETECTION SYSTEM AND DIGITAL HANDWRITING PEN**

(30) Priority: 16.01.2019 CN 201910042522
(71) Applicant: Shenzhen Huion Animation Technology Co., Ltd., Shenzhen, Guangdong 518103 (CN)
(72) Inventor: LUO, Yong, Shenzhen, Guangdong 518103 (CN); ZHANG, Peng Cheng, Shenzhen, Guangdong 518103 (CN); WU, Shi Hua, Shenzhen, Guangdong 518103 (CN); WANG, Zhou Hong, Shenzhen, Guangdong 518103 (CN)
(74) Representative: Miao, Tianhao
(86) International application number: PCT/CN2020/071087
(87) International publication number: WO 2020/147638

(57) **Abstract**

A position detection system, comprising a power supply module 10, a detection module 50, a control module 30, and a pulse module 70. The power supply module 10 is used for supplying power, so as to ensure that parts in the position detection system are operated normally. The detection module 50 comprises a key detection circuit 51, a pressure detection circuit 53 and an angle detection circuit 55; the key detection circuit 51 is used for providing key detection data and the key detection is output after being processed by means of the control module 30; and the pressure detection circuit 53 is used for providing pressure detection data and the pressure detection data is output after being processed by means of the control module 30. The control module 30 is used for outputting a signal after the detection data are processed. The pulse module 70 is connected to the control module 30, and the pulse module 70 is used for obtaining starting references of a key signal and a pressure signal output by the control module 30, and converting the key signal and the pressure signal into digital signals by formal coding and then sending the digital signals to a handwriting board. Compared with the related art, the position detection system and the digital handwriting pen have better stability.

## Description

### FIELD OF THE PRESENT DISCLOSURE

The present disclosure relates to the technical field of computer peripheral devices, and more particular, relates to a position detection system and a digital stylus using the same.

### DESCRIPTION OF RELATED ART

With advancement of technologies, digital electronic information devices have a trajectory input function. This function is generally implemented in a handwriting fashion. As digital electronic information devices, digital styluses are widely used. The digital stylus is not only capable of implementing text input by handwriting, but also capable of implementing drawing, point control, and the like functions.

In the related art, the digital stylus is usually used together with a matching tablet, and functions such as a force and a key need to be equipped on the digital stylus. The digital stylus implements detection of the functions such as the force and the key in two fashions:

By changing oscillation parameters of the digital stylus, an induction frequency received by the tablet is changed to determine the key and the magnitude of the sensed force. However, under the force of the stylus, relative positions of a stylus coil and a magnetic core are changed, an oscillation frequency of the stylus is changed, and then the magnitude of the sensed force is determined, such that requirements of frequency accuracy are too high, manufacturing is difficult, and uncertainty is present in the magnitude of the force in an enabled state of the stylus, that is, a problem that the handwriting is unstable is caused.

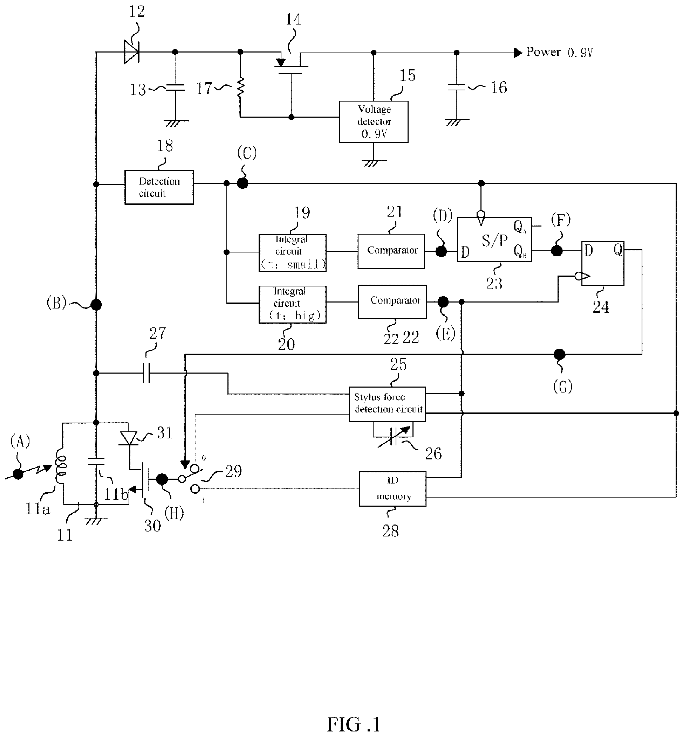

Further, in the fashion disclosed in CN101174192A, by a position detection device and a position indicator, data of the key processing is digitally transmitted, but the sensed force is determined, based on a signal of an induction frequency F0 from the tablet, in accordance with time changes of charging or discharging of a time constant circuit constituted by a variable capacitor. Since the induced frequency F0 is changed with the change of external factors of the stylus and the tablet, the detection of the sensed force is unstable. In a stylus force detection circuit 25 as illustrated in FIG. 1, a stylus force applied on a variable capacitor 26, with variable capacitances, corresponding to the stylus force is converted to a digital value, and the digital value is output corresponding to a pulse from a detection circuit 18. The stylus force detection circuit 25 digitalizes time of charging or discharging of the time constant circuit constituted by a variable capacitor 26 by calculating a signal of the frequency F0 input by a capacitor 27, and a resonance frequency F0 of the stylus force detection circuit 25 is affected by external environments, such that accuracy of the sensed force is not ensured.

Therefore, it is desired to provide a position detection system and a digital stylus to address the above problem.

### SUMMARY OF THE PRESENT DISCLOSURE

In order to accomplish above problem of the instability of handwriting caused by the uncertainty present in the force and the key in an enabled state of the stylus, the present disclosure provides a position detection system and a digital stylus to address the above problem.

A position detection system includes a power module, a detection module, a control module, and a pulse module, the power module is configured to supply power to ensure that various components in the position detection system are capable of normally operating, the detection module includes a key detection circuit and a force detection circuit, the key detection circuit is configured to supply key detection data and output processed data in response to the key detection data being processed by the control module, and the force detection circuit is configured to supply force detection data and output data in response to the force detection data being processed by the control module, the control module is electrically connected to the power module and the detection module, and configured to process the key detection data detected by the key detection circuit and the force detection data detected by the force detection circuit and output a key signal and a force signal, and the pulse module is connected to the control module, and configured to acquire start references of the key signal and the force signal output by the control module, and convert the key signal and the force signal to digital signals by form coding and send the digital signals to a tablet.

According to a preferred embodiment, the power module includes a resonance circuit and a power extraction circuit, wherein the resonance circuit includes a coil and a first capacitor, and the power extraction circuit is configured to extract a power source from an induction voltage induced from the coil.

According to a preferred embodiment, the power extraction circuit at least includes a diode and a second capacitor, wherein when a voltage generated by the resonance circuit is higher than a voltage on the second capacitor, the resonance circuit charges the second capacitor.

According to a preferred embodiment, the power module further includes a power voltage regulation circuit, wherein the power source extracted by the power extraction circuit is formed to a stable power source by the power voltage regulation circuit and output to the various components in the position detection system.

According to a preferred embodiment, the force detection circuit includes a force sensor, wherein the force sensor is configured to convert a detected force into an electrical signal.

According to a preferred embodiment, the key detection circuit includes a key, wherein the key is a switch-type key or a touch-type key.

According to a preferred embodiment, the detection module further includes an angle detection circuit electrically connected to the control module, wherein the angle detection circuit is configured to supply inclination angle detection data and output processed data in response to the inclination angle detection data being processed by the control module.

According to a preferred embodiment, the pulse module includes a data transmission reference detection circuit and a pulse modulation circuit, wherein the data transmission reference detection circuit is configured to detect a falling edge upon completion of charging by the power module as the start references of the key signal and the force signal that are sent by the detection module to the tablet.

According to a preferred embodiment, the pulse modulation circuit is a circuit obtained by parameter adjustment of the data transmission reference detection circuit, and the pulse modulation circuit is configured to quantize the key signal and the force signal detected by the detection module, and convert the key signal and the force signal to digital signals by form coding and send the digital signals to the tablet.

A digital stylus includes a position detection system, the position detection system includes a power module, a detection module, a control module, and a pulse module, the power module is configured to supply power to ensure that various components in the position detection system are capable of normally operating, the detection module includes a key detection circuit and a force detection circuit, the key detection circuit is configured to supply key detection data and output processed data in response to the key detection data being processed by the control module, and the force detection circuit is configured to supply force detection data and output data in response to the force detection data being processed by the control module, the control module is electrically connected to the power module and the detection module, and configured to process the key detection data detected by the key detection circuit and the force detection data detected by the force detection circuit and output a key signal and a force signal, and the pulse module is connected to the control module, and configured to acquire start references of the key signal and the force signal output by the control module, and convert the key signal and the force signal to digital signals by form coding and send the digital signals to a tablet.

Compared with the related art, in the position detection system according to the present disclosure, the key detection circuit, and the detection circuit are added, and the key signal and force signal are both transmitted in the digital fashion. This reduces impacts caused by other factors to the stylus force and the key, and thus stability of the position detection system is improved. In addition, the inclination angle is detected by the angle detection module, and the inclination angle detection data is transmitted in the digital fashion, thereby reduces influence of other factors to the inclination angle. Correspondingly, the digital stylus uses the position detection system, and thus stability of the digital stylus is improved.

### BRIEF DESCRIPTION OF THE DRAWINGS

Many aspects of the exemplary embodiments can be better understood with reference to the following drawings. The components in the drawing are not necessarily drawn to scale, the emphasis instead being placed upon clearly illustrating the principles of the present disclosure.
FIG. 1 a structural block diagram of a position detection device according to a related art;
FIG. 2 is a structural block diagram of a position detection system according to the present disclosure;
FIG. 3 is a structural block diagram of the key detection circuit as illustrated in FIG. 2;
FIG. 4 is a structural block diagram of the key detection circuit as illustrated in FIG. 2;
FIG. 5 is a schematic diagram of data communication transmission benchmark of a digital stylus; and
FIG. 6 is a schematic diagram of data communication between a digital stylus and a tablet.

### DETAILED DESCRIPTION OF THE EXEMPLARY EMBODIMENTS

The present disclosure will hereinafter be described in detail with reference to several exemplary embodiments. To make the technical problems to be solved, technical solutions and beneficial effects of the present disclosure more apparent, the present disclosure is described in further detail together with the figure and the embodiments. It should be understood the specific embodiments described hereby is only to explain the disclosure, not intended to limit the disclosure.

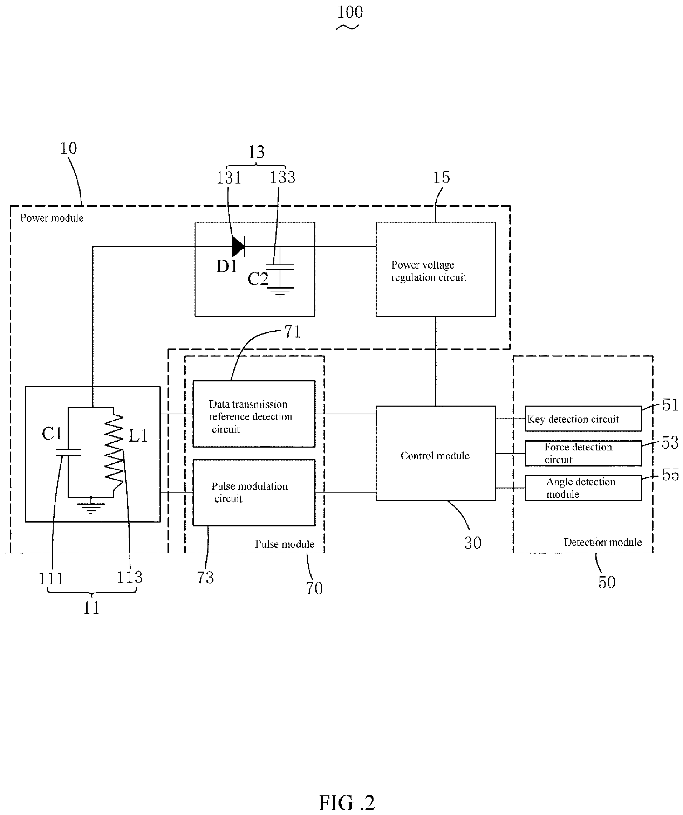

Referring to FIG. 2, a structural block diagram of a position detection system according to the present disclosure is illustrated. The present disclosure provides a position detection system 100. The position detection system 100 includes a power module 10, a control module 30, a detection module 50, and a pulse module 70.

The power module 10 is configured to supply power to ensure that various components in the position detection system 100 are capable of normally operating.

The control module 30 is connected to the power module 10, the detection module 50, and the pulse module 70, and configured to detect data for the detection module 50, and output processed data in response to the detected data being processed by the pulse module 70.

The detection module 50 is electrically connected to the control module 30, and includes a key detection circuit 51, a force detection circuit 53, and an angle detection module 55. The key detection circuit 51 is configured to supply key detection data and output processed data in response to the key detection data being processed by the control module 30, and the force detection circuit 53 is configured to supply force detection data and output data in response to the force detection data being processed by the control module 30; and the angle detection module 55 is configured to supply inclination angle detection data and output data in response to the inclination angle detection data being processed by the control module 30.

The pulse detection module 70 includes a data transmission reference detection circuit 71 and a pulse modulation circuit 73. The data transmission reference detection circuit 71 is configured to acquire start references of a key signal, a force signal, and an inclination angle signal output by the control module 30. The pulse modulation circuit 73 is configured to quantize the key signal, the force signal, and the inclination angle signal detected by the detection module, and convert the key signal and, the force signal and the inclination angle signal to digital signals by form coding and send the digital signals to a tablet.

Specifically, the power module 10 includes a resonance circuit 11, a power extraction circuit 13, and a power voltage regulation circuit 15. The resonance circuit 11 includes a coil 111 and a first capacitor 113. The coil 111 and the first capacitor 113 collaboratively constitute the resonance circuit 11 with a predetermined frequency. The power extraction circuit 13 is configured to extract a power source from the resonance circuit 11. Specifically, the power extraction circuit 13 extracts the power source from an induction voltage induced from the coil 111, and is constituted by a diode 131 and a second capacitor 133. When a voltage generated on the resonance circuit 11 is higher than a voltage corresponding to a holding voltage on the second capacitor 133, the resonance circuit 11 charges the second capacitor 133. After forming a stable power source desired by the position detection system 100 from the power source extracted by the power extraction circuit 13, the power voltage regulation circuit 15 outputs the stable power source to the various components in the position detection system 100 to maintain an output voltage substantially unchanged, such that it is ensured that various components in the position detection system 100 are capable of normally operating.

In this embodiment, the power module 10 acquires electric power from the resonance circuit 11 and the power extraction circuit 13. Nevertheless, in other embodiments, the power module may acquire the electric power in other fashions, as long as the power module 10 is capable of supplying power to the various components in the position detection system 100, and ensuring that the various components in the position detection system 100 are capable of normally operating.

In this embodiment, preferably, the power module 10 acquires the power from the resonance circuit 11, and the power extraction circuit 13. In this case, a digital stylus using the position detection system 100 does not need to be equipped with a battery, such that a weight of the digital stylus is effectively reduced, and use of the stylus becomes easier and more convenient for a user.

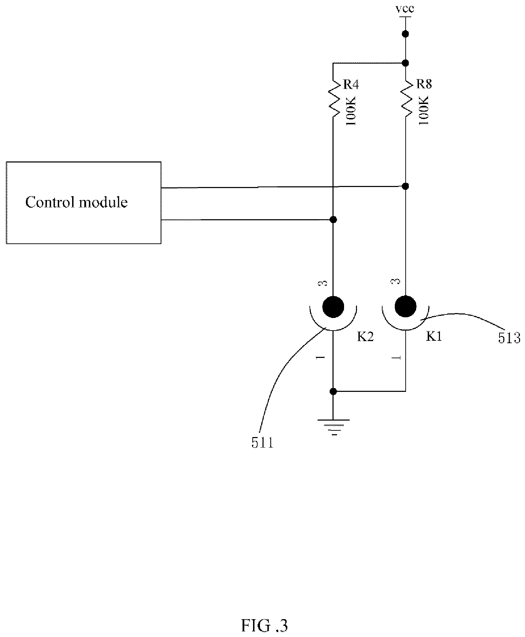

Referring to FIG. 3, FIG. 3 is a structural block diagram of the key detection circuit as illustrated in FIG. 2. The key detection circuit 51 includes a first key 511 and a second key 513. The first key 511 and the second key 513 are detected by the control module 30, and subjected to key debounce so as to be transmitted to the tablet. The debounce processing includes hardware debounce and software debounce. The hardware debounce is used in the case where the number of keys is small, and the software debounce is used in the case where the number of keys is large. In this embodiment, the hardware debounce is used. Specifically, a switch used for the key debounce is a mechanical elastic switch.

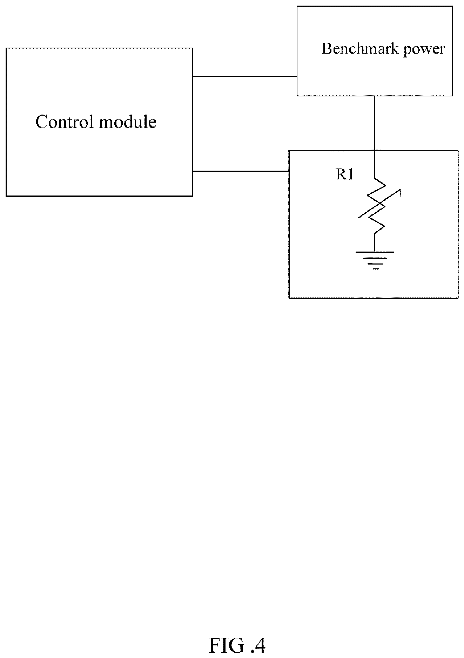

Referring to FIG. 4, FIG. 4 is a structural block diagram of the key detection circuit as illustrated in FIG. 2. Detection of a force by the force detection circuit 53 is performed by an independent force sensor R1, and an accurate force absolute value may be detected and read by the control module 30 such that the force absolute value is transmitted to the tablet via communication. The force sensor may be any sensor in the related art that converts the force into an electric signal.

Detection of an inclination angle of the angle detection module 55 is performed by an independent angle sensor, and a value of the inclination angle is detected and read by the control module 30 such that the value is transmitted to the tablet via communication. The angle sensor may be any sensor in the related art that converts the inclination angle into an electric signal.

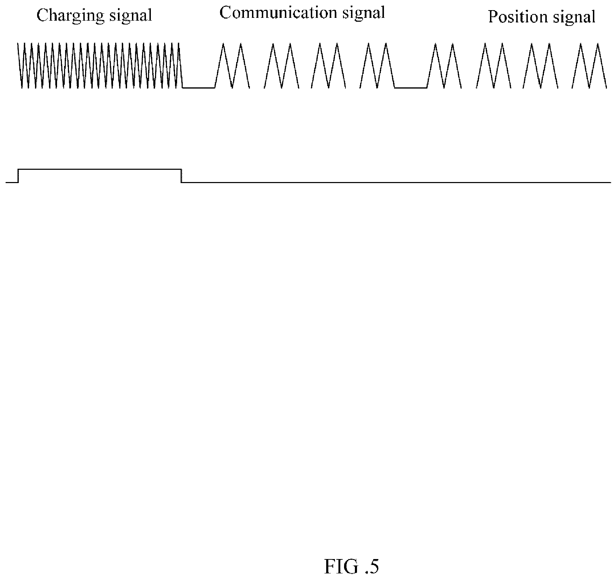

Referring to FIG. 5, FIG. 5 is a schematic diagram of data communication transmission benchmark of a digital stylus. After the control module 30 receives a signal from the detection module 50, a falling edge upon completion of charging by the power module 10 as illustrated in FIG. 5 that is detected by the data transmission reference detection circuit 71 is a start reference for communication of the digital stylus. That is, the falling edge of the charging signal is a start reference of a communication signal.

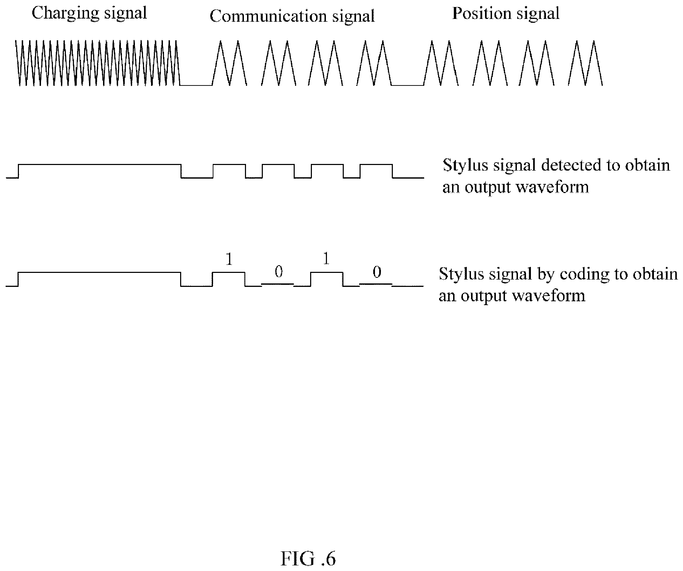

Referring to FIG. 6, FIG. 6 is a schematic diagram of data communication between a digital stylus and a tablet. The pulse modulation circuit 73 is a circuit obtained by parameter adjustment of the data transmission reference detection circuit71. The pulse modulation circuit 73 detects a waveform from the signals following the start reference for a stylus signal of the digital stylus, and acquires the digital signals that are sent to the tablet by form coding. The stylus signal of the digital stylus is a key signal detected by the key detection circuit 51, a force signal detected by the force detection circuit 53, or an inclination angle signal detected by the angle detection circuit 55. Upon sampling the communication signal, the pulse modulation circuit 73 quantizes information of the key signal, the force signal, and the inclination angle signal detected in the detection module 50, and converts the key signal, the force signal, and the inclination angle signal to digital signals by form coding and sends the digital signals to the tablet. As illustrated in FIG. 6, the stylus signal is modulated into a waveform and is represented by a digital signal, and the digital signal is sent to the tablet in this fashion: a "1" signal to be transmitted is transmitted while being maintained unchanged, and a "0" signal to be transmitted is transmitted with a pulse of the signal being controlled to "0" by the control module 30. In addition, the digital signal may be sent to the tablet in another fashion: a "0" signal to be transmitted is transmitted while being maintained unchanged, and a "1" signal to be transmitted is transmitted with pulse of the signal being controlled to "0" by the control module 30.

An operating principle of the position detection system 100 is as follows: the control module 30 is in a standby state upon completion of communication, and in response to receiving a rising edge of the charging signal generated by the power module 10 as illustrated in FIG. 5, that is, the rising edge is triggered, the control module 30 is waken up; during the charging process provided by the power module 10, the control module 30 performs signal detection on the key detection circuit 51, the force detection circuit 53, and the angle detection circuit 55; upon completion of charging by the power module 10, the falling edge of the control module 30 is the beginning of the communication signal; in this case, the communication signal of the stylus signal to be transmitted such as the key signal detected by the key detection circuit 51, the force signal detected by the force detection circuit 53, or the inclination angle signal detected by the angle detection circuit 55 is modulated by coding to obtain an output waveform as illustrated in FIG. 6. Upon receiving the signal, the tablet may decode, using a predetermined communication protocol, the information of the key signal, a stylus force signal, and the inclination angle signal of the digital stylus.

In the meantime, the present disclosure further provides a digital stylus (not illustrated). The digital stylus includes the position detection system 100. It may be understood that the key signal, the force signal, and the inclination angle signal is transmitted between the digital stylus and the tablet in a digital fashion, such that instability caused by other factors to the key, the stylus force, and the inclination angle is reduced, and detection and identification of the key, the stylus force, and the inclination angle, between the digital stylus and the tablet becomes more accurate.

Compared with the related art, in the position detection system according to the present disclosure, the key detection circuit 51, and the detection circuit 53 are added, and the key signal and force signal are both transmitted in the digital fashion. This reduces impacts caused by other factors to the stylus force and the key, and thus stability of the position detection system is improved. In addition, the inclination angle is detected by the angle detection module 55, and the inclination angle detection data is transmitted in the digital fashion, thereby reduces influence of other factors to the inclination angle. Correspondingly, the digital stylus uses the position detection system, and thus stability of the digital stylus is improved.

It is to be understood, however, that even though numerous characteristics and advantages of the present exemplary embodiments have been set forth in the foregoing description, together with details of the structures and functions of the embodiments, the disclosure is illustrative only, and changes may be made in detail, especially in matters of shape, size, and arrangement of parts within the principles of the invention to the full extent indicated by the broad general meaning of the terms where the appended claims are expressed.

## Claims

1. A position detection system, comprising a power module, a detection module, a control module, and a pulse module; wherein
the power module is configured to supply power to ensure that various components in the position detection system are capable of normally operating;
the detection module comprises a key detection circuit and a force detection circuit, wherein the key detection circuit is configured to supply key detection data and output processed data in response to the key detection data being processed by the control module, and the force detection circuit is configured to supply force detection data and output data in response to the force detection data being processed by the control module;
the control module is electrically connected to the power module and the detection module, and configured to process the key detection data detected by the key detection circuit and the force detection data detected by the force detection circuit and output a key signal and a force signal; and
the pulse module is connected to the control module, and configured to acquire start references of the key signal and the force signal output by the control module, and convert the key signal and the force signal to digital signals by form coding and send the digital signals to a tablet.

2. The position detection system according to claim 1, wherein the power module comprises a resonance circuit and a power extraction circuit, wherein the resonance circuit comprises a coil and a first capacitor, and the power extraction circuit is configured to extract a power source from an induction voltage induced from the coil.

3. The position detection system according to claim 2, wherein the power extraction circuit at least comprises a diode and a second capacitor, wherein when a voltage generated by the resonance circuit is higher than a voltage on the second capacitor, the resonance circuit charges the second capacitor.

4. The position detection system according to claim 2, wherein the power module further comprises a power voltage regulation circuit, wherein the power source extracted by the power extraction circuit is formed to a stable power source by the power voltage regulation circuit and output to the various components in the position detection system.

5. The position detection system according to claim 1, wherein the force detection circuit comprises a force sensor, wherein the force sensor is configured to convert a detected force into an electrical signal.

6. The position detection system according to claim 1, wherein the key detection circuit comprises a key, wherein the key is a switch-type key or a touch-type key.

7. The position detection system according to claim 1, wherein the detection module further comprises an angle detection circuit electrically connected to the control module, wherein the angle detection circuit is configured to supply inclination angle detection data and output processed data in response to the inclination angle detection data being processed by the control module.

8. The position detection system according to claim 3, wherein the pulse module comprises a data transmission reference detection circuit and a pulse modulation circuit, wherein the data transmission reference detection circuit is configured to detect a falling edge upon completion of charging by the power module as the start references of the key signal and the force signal that are sent by the detection module to the tablet.

9. The position detection system according to claim 8, wherein the pulse modulation circuit is a circuit obtained by parameter adjustment of the data transmission reference detection circuit, and the pulse modulation circuit is configured to quantize the key signal and the force signal detected by the detection module, and convert the key signal and the force signal to digital signals by form coding and send the digital signals to the tablet.

10. A digital stylus, comprising the position detection system as defined in any one of claims 1 to 9.
